# EUROPEAN PATENT SPECIFICATION

(11) **EP 3 238 077 B1**
(45) Date of publication and mention of the grant of the patent: **03.08.2022**
(21) Application number: 15874018.3
(22) Date of filing: 24.11.2015
(51) Int. Cl.: G06F 13/16, G06F 12/02, G06F 11/14, G11C 5/04, G11C 5/14, G11C 7/20, G06F 1/30, G06F 12/0868, G06F 12/0804, G06F 11/20, G06F 12/0811

(54) **FAULT TOLERANT AUTOMATIC DUAL IN-LINE MEMORY MODULE REFRESH**
AKTUALISIERUNG EINES AUTOMATISCHEN FEHLERTOLERANTEN DIMM-MODULS
RAFRAÎCHISSEMENT D'UN DOUBLE MODULE DE MÉMOIRE EN LIGNE AUTOMATIQUE INSENSIBLE AUX DÉFAILLANCES

(30) Priority: 24.12.2014 US 201414583037
(43) Date of publication of application: 01.11.2017
(73) Proprietor: Intel Corporation, Santa Clara, CA 95054 (US)
(72) Inventor: JAYAKUMAR, Sarathy, Portland, Oregon 97229 (US); KUMAR, Mohan J., Aloha, Oregon 97007 (US)
(74) Representative: Rummler, Felix
(86) International application number: PCT/US2015/062555
(87) International publication number: WO 2016/105814

(56) References cited:
- WO-A1-03/060716
- US-A1- 2006 015 683
- US-A1- 2006 080 515
- US-A1- 2010 011 155
- US-A1- 2010 080 057
- US-A1- 2010 202 240
- US-A1- 2010 202 240
- US-A1- 2013 019 076
- US-A1- 2014 181 367
- US-B1- 7 954 006
- PAN XIANG ET AL: "NVSleep: Using non-volatile memory to enable fast sleep/wakeup of idle cores", 2014 IEEE 32ND INTERNATIONAL CONFERENCE ON COMPUTER DESIGN (ICCD), IEEE, 19 October 2014 (2014-10-19), pages 400-407, XP032695588, DOI: 10.1109/ICCD.2014.6974712 [retrieved on 2014-12-03]

## Description

### FIELD

The present disclosure generally relates to the field of electronics. More particularly, some embodiments generally relate to fault tolerant automatic dual in-line memory module refresh.

### BACKGROUND

Generally, memory used to store data in a computing system can be volatile (to store volatile information) or non-volatile (to store persistent information). Volatile data structures stored in volatile memory are generally used for temporary or intermediate information that is required to support the functionality of a program during the run-time of the program. On the other hand, persistent data structures stored in non-volatile (or persistent memory) are available beyond the run-time of a program and can be reused.

When data is written to persistent memory, an assumption is made that such data is actually written to persistent memory once the store operation is completed. However, data destined for persistent memory may still reside in volatile memory/buffers after execution of the store operation and before the data is actually saved persistent memory. If a system fault (such as a power failure) occurs during this gap in time, the data destined for persistent memory may be lost or damage.

US2006/080515A1 relates to a data storage system including a primary data storage device and a backup data storage device stores data with enhanced performance. The primary data storage device has a primary data storage device memory for holding data, and the backup data storage device has a backup volatile memory, a backup non-volatile memory, and a processor. The backup storage device processor causes a copy of data provided to the primary data storage device to be provided to the backup data storage device volatile memory, and in the event of a power interruption moves the data from the backup volatile memory to the backup non-volatile memory.

"NVSleep: Using non-volatile memory to enable data sleep/wakeup of idle cores" by Pan Xiang Et Al [IEEE 32ND INTERNATIONAL CONFERENCE ON COMPUTER DESIGN (ICCD), IEEE, 19 October 2014 (2014-10-19), pages 400-407] proposes a lowpower microprocessor framework that purports to leverage STT-RAM to implement rapid shutdown of cores without loss of execution state.

US2010/202240A1 relates to A device includes: non-volatile memory; a controller in communication with the non-volatile memory, wherein the controller is programmed to move data from a volatile memory to the non-volatile memory upon a loss of power of a primary power source of the volatile memory; and a backup power supply providing temporary power to the controller and the volatile memory upon the loss of power of the primary power source, including: a capacitor bank with an output terminal; a connection to a voltage source that charges the capacitor bank to a normal operating voltage; and a state-of-health monitor that is programmed to generate a failure signal based on a voltage at the output terminal of the capacitor bank.

US2010/011155A1 relates to a data processor includes a flash memory that stores a plurality of types of data therein, a random access memory that stores record data information therein, and a controller that can access the flash memory and the RAM.

### BRIEF DESCRIPTION OF THE DRAWINGS

The detailed description is provided with reference to the accompanying figures. In the figures, the left-most digit(s) of a reference number identifies the figure in which the reference number first appears. The use of the same reference numbers in different figures indicates similar or identical items.
Figs. 1, 2, 5, 6, and 7 illustrate block diagrams of embodiments of computing systems, which may be utilized to implement various embodiments discussed herein.
Fig. 3 illustrates a block diagram of various components present on a processor Integrated Circuit (IC) die, according to an embodiment.
Figs. 4A and 4B illustrate flow diagrams in accordance with some embodiments.

### DETAILED DESCRIPTION

In the following description, numerous specific details are set forth in order to provide a thorough understanding of various embodiments. However, various embodiments may be practiced without the specific details. In other instances, well-known methods, procedures, components, and circuits have not been described in detail so as not to obscure the particular embodiments. Further, various aspects of embodiments may be performed using various means, such as integrated semiconductor circuits ("hardware"), computer-readable instructions organized into one or more programs ("software"), or some combination of hardware and software. For the purposes of this disclosure reference to "logic" shall mean either hardware, software, or some combination thereof.

As indicated above, unlike volatile main memory, persistent memory may be used to store data durably, so that, the stored data is available across system failures, resets, and/or restarts. Software considers that data written to a persistence memory range has reached durability as soon as the store instruction completes, but that data could still be residing in volatile buffers (such as memory controller write pending queue or processor caches). To ensure that data in these volatile buffers reach persistent memory, either an ADR (or Automatic DIMM (Dual In-line Memory Module) Refresh) mechanism or PCOMMIT (which is an instruction in accordance with an Instruction Set Architecture) is used.

An ADR mechanism can be used for both processor generated write operations to persistent memory or in-bound Input/Output (IO or I/O) write operations directed at persistent memory. ADR is a legacy mechanism that flushes the memory controller buffers (e.g., Write Pending Queue) and IIO (Integrated IO) buffers (which hold in-bound data in an embodiment) in response to AC (Alternating Current) power failure. Enhanced ADR may extend this power failure protection to the processor caches as well. In the event of a power failure, both ADR and enhanced ADR (eADR) rely on platform bulk capacitance to hold the DC (Direct Current) rails powered for a brief amount of time to allow for the processor to flush its caches and buffers. In either of the above scenarios, the fundamental premise is that ADR should be successful at all times, to prevent any data loss. Similarly, if PCOMMIT is used, the semantics of the PCOMMIT require global flushing of all iMC (integrated Memory Controller) WPQs (Write Pending Queues) which could limit performance.

To this end, some embodiments provide fault tolerant ADR techniques. For example, an embodiment provides a mechanism for achieving reliable persistence for NVDIMMs (NonVolatile Dual In-line Memory Modules) in the face of platform failures (such as link or VR (Voltage Regulator) failures) during ADR. In one embodiment, a processor includes non-volatile memory to store data from one or more volatile buffers of the processor. The data from the one or more volatile buffers of the processor are stored into the non-volatile memory in response to occurrence of an event that is to lead to a system reset or shut down. The stored data can then be restored from the non-volatile memory on the next reboot.

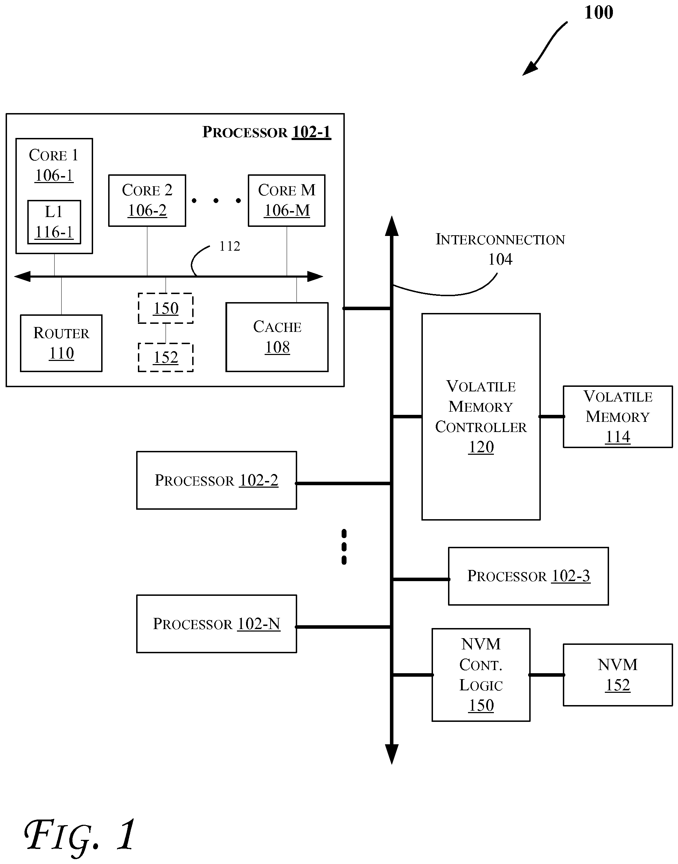

Moreover, the techniques discussed herein may be provided in various computing systems (e.g., including a non-mobile computing device such as a desktop, workstation, server, rack system, etc. and a mobile computing device such as a smartphone, tablet, UMPC (Ultra-Mobile Personal Computer), laptop computer, Ultrabook^{™} computing device, smart watch, smart glasses, smart bracelet, etc.), including those discussed with reference to Figs. 1-7. More particularly, Fig. 1 illustrates a block diagram of a computing system 100, according to an embodiment. The system 100 includes one or more processors 102-1 through 102-N (generally referred to herein as "processors 102" or "processor 102"). The processors 102 may communicate via an interconnection or bus 104. Each processor may include various components some of which are only discussed with reference to processor 102-1 for clarity. Accordingly, each of the remaining processors 102-2 through 102-N may include the same or similar components discussed with reference to the processor 102-1.

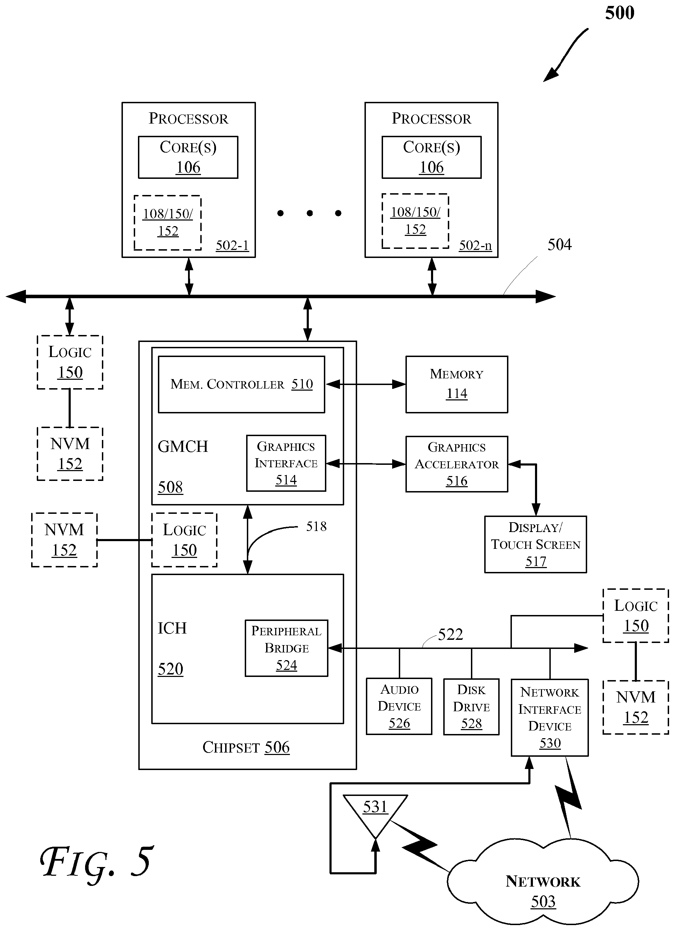

In an embodiment, the processor 102-1 may include one or more processor cores 106-1 through 106-M (referred to herein as "cores 106," or more generally as "core 106"), a cache 108 (which may be a shared cache or a private cache in various embodiments), and/or a router 110. The processor cores 106 may be implemented on a single integrated circuit (IC) chip. Moreover, the chip may include one or more shared and/or private caches (such as cache 108), buses or interconnections (such as a bus or interconnection 112), logic 120, logic 150, memory controllers (such as those discussed with reference to Figs. 5-7), Non-Volatile Memory (NVM) 152 (e.g., including flash memory, a Solid State Drive (SSD), etc.), or other components.

In one embodiment, the router 110 may be used to communicate between various components of the processor 102-1 and/or system 100. Moreover, the processor 102-1 may include more than one router 110. Furthermore, the multitude of routers 110 may be in communication to enable data routing between various components inside or outside of the processor 102-1.

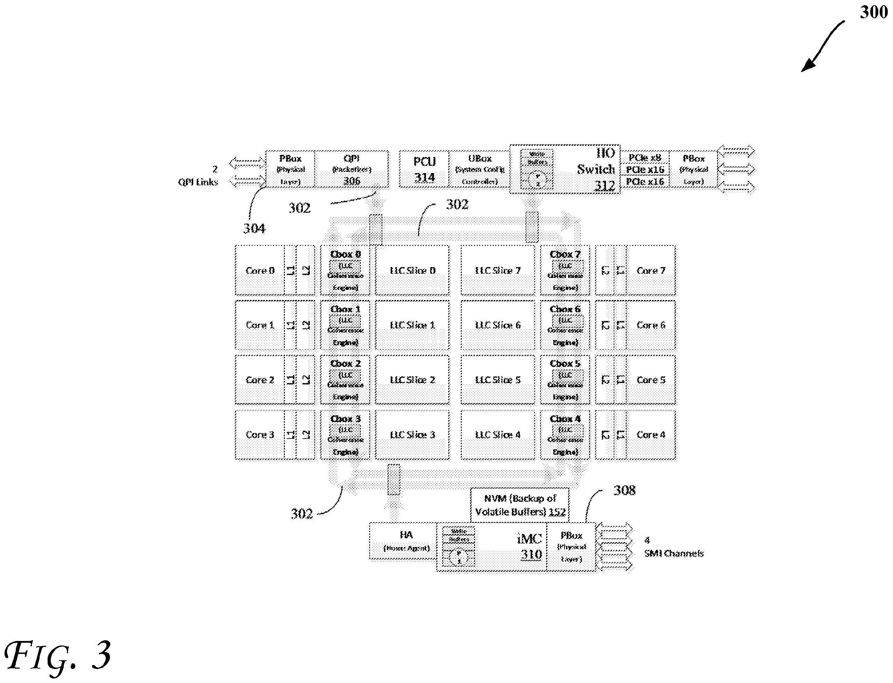

The cache 108 may store data (e.g., including instructions) that are utilized by one or more components of the processor 102-1, such as the cores 106. For example, the cache 108 may locally cache data stored in a volatile memory 114 for faster access by the components of the processor 102. As shown in Fig. 1, the memory 114 may be in communication with the processors 102 via the interconnection 104. In an embodiment, the cache 108 (that may be shared) may have various levels, for example, the cache 108 may be a mid-level cache and/or a Last-Level Cache (LLC). Also, each of the cores 106 may include a Level 1 (LI) cache (116-1) (generally referred to herein as "L1 cache 116") and/or Level 2 (L2) cache (e.g., discussed with reference to Fig. 3). Various components of the processor 102-1 may communicate with the cache 108 directly, through a bus (e.g., the bus 112), and/or a memory controller or hub.

As shown in Fig. 1, memory 114 may be coupled to other components of system 100 through a volatile memory controller 120. System 100 also includes NVM memory controller logic 150 to couple NVM memory 152 to various components of the system 100. Memory 152 includes nonvolatile memory such as nanowire memory, Ferro-electric transistor random access memory (FeTRAM), magnetoresistive random access memory (MRAM), flash memory, Spin Torque Transfer Random Access Memory (STTRAM), Resistive Random Access Memory, byte addressable 3-Dimensional Cross Point Memory, PCM (Phase Change Memory), etc. in some embodiments.

Furthermore, even though the memory controller 150 is shown to be coupled between the interconnection 104 and the memory 152, the logic 150 may be located elsewhere in system 100. For example, logic 150 (or portions of it) may be provided within one of the processors 102, controller 120, etc. in various embodiments. In an embodiment, logic 150 and NVM 152 are included in an SSD. Moreover, logic 150 controls access to one or more NVM devices 152 (e.g., where the one or more NVM devices are provided on the same integrated circuit die in some embodiments), as discussed herein with respect to various embodiments. Also, memory controller 120 and NVM controller 150 may be combined into a single controller in an embodiment.

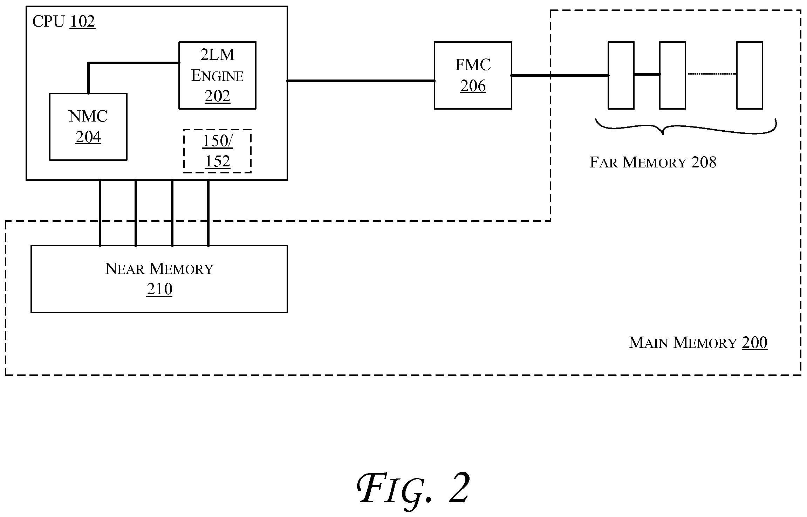

Fig. 2 illustrates a block diagram of two-level system main memory, according to an embodiment. Some embodiments are directed towards system main memory 200 comprising two levels of memory (alternatively referred to herein as "2LM") that include cached subsets of system disk level storage (in addition to, for example, run-time data). This main memory includes a first level memory 210 (alternatively referred to herein as "near memory") comprising smaller faster memory made of, for example, volatile memory 114 (e.g., including DRAM (Dynamic Random Access Memory)), NVM 152, etc.; and a second level memory 208 (alternatively referred to herein as "far memory") which comprises larger and slower (with respect to the near memory) volatile memory (e.g., memory 114) or nonvolatile memory storage (e.g., NVM 152).

In an embodiment, the far memory is presented as "main memory" to the host Operating System (OS), while the near memory is a cache for the far memory that is transparent to the OS, thus rendering the embodiments described below to appear the same as general main memory solutions. The management of the two-level memory may be done by a combination of logic and modules executed via the host central processing unit (CPU) 102 (which is interchangeably referred to herein as "processor"). Near memory may be coupled to the host system CPU via one or more high bandwidth, low latency links, buses, or interconnects for efficient processing. Far memory may be coupled to the CPU via one or more low bandwidth, high latency links, buses, or interconnects (as compared to that of the near memory).

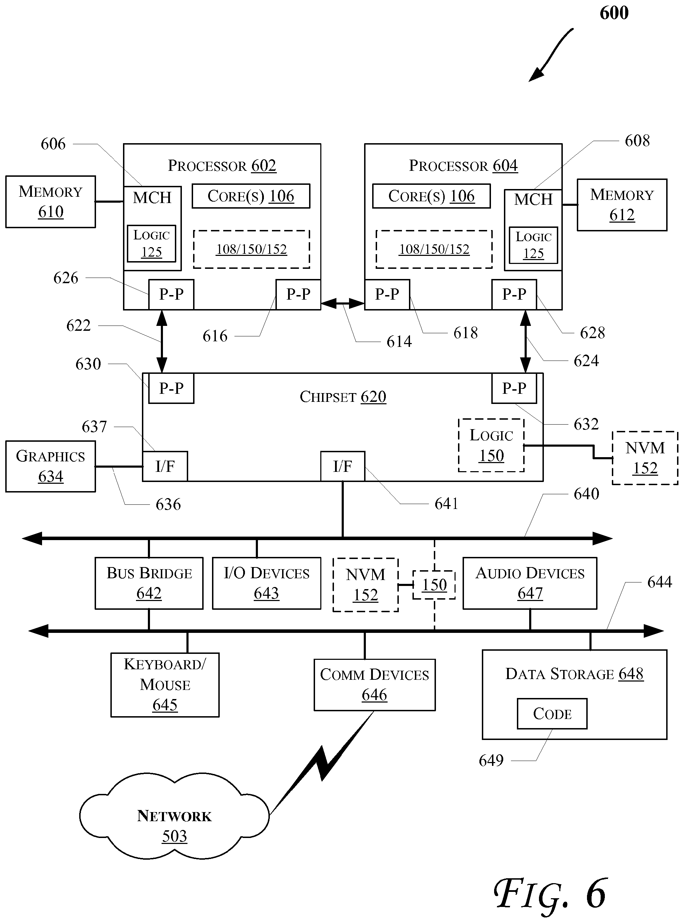

Referring to Fig. 2, main memory 200 provides run-time data storage and access to the contents of system disk storage memory (such as disk drive 528 of Fig. 5 or data storage 648 of Fig. 6) to CPU 102. The CPU may include cache memory, which would store a subset of the contents of main memory 200. Far memory may comprise either volatile or nonvolatile memory as discussed herein. In such embodiments, near memory 210 serves a low-latency and highbandwidth (i.e., for CPU 102 access) cache of far memory 208, which may have considerably lower bandwidth and higher latency (i.e., for CPU 102 access).

In an embodiment, near memory 210 is managed by Near Memory Controller (NMC) 204, while far memory 208 is managed by Far Memory Controller (FMC) 206. FMC 206 reports far memory 208 to the system OS as main memory (i.e., the system OS recognizes the size of far memory 208 as the size of system main memory 200). The system OS and system applications are "unaware" of the existence of near memory 210 as it is a "transparent" cache of far memory 208.

CPU 102 further comprises 2LM engine module/logic 202. The "2LM engine" is a logical construct that may comprise hardware and/or micro-code extensions to support two-level main memory 200. For example, 2LM engine 202 may maintain a full tag table that tracks the status of all architecturally visible elements of far memory 208. For example, when CPU 102 attempts to access a specific data segment in main memory 200, 2LM engine 202 determines whether the data segment is included in near memory 210; if it is not, 2LM engine 202 fetches the data segment in far memory 208 and subsequently writes the data segment to near memory 210 (similar to a cache miss). It is to be understood that, because near memory 210 acts as a "cache" of far memory 208, 2LM engine 202 may further execute data perfecting or similar cache efficiency processes.

Further, 2LM engine 202 may manage other aspects of far memory 208. For example, in embodiments where far memory 208 comprises nonvolatile memory (e.g., NVM 152), it is understood that nonvolatile memory such as flash is subject to degradation of memory segments due to significant reads/writes. Thus, 2LM engine 202 may execute functions including wear-leveling, bad-block avoidance, and the like in a manner transparent to system software. For example, executing wear-leveling logic may include selecting segments from a free pool of clean unmapped segments in far memory 208 that have a relatively low erase cycle count.

In some embodiments, near memory 210 may be smaller in size than far memory 208, although the exact ratio may vary based on, for example, intended system use. In such embodiments, it is to be understood that because far memory 208 may comprise denser and/or cheaper nonvolatile memory, the size of the main memory 200 may be increased cheaply and efficiently and independent of the amount of DRAM (i.e., near memory 210) in the system.

In one embodiment, far memory 208 stores data in compressed form and near memory 210 includes the corresponding uncompressed version. Thus, when near memory 210 request content of far memory 208 (which could be a non-volatile DIMM in an embodiment), FMC 206 retrieves the content and returns it in fixed payload sizes tailored to match the compression algorithm in use (e.g., a 256B transfer).

As discussed above, current solutions for addressing fault tolerance in a computing system pose various issues. For example, some current solutions may pose the following problems:
(1) One inherent risk in the ADR or eADR mechanisms is that any failure by the platform to flush these data on AC power failure generally leads to data loss. For example, these failures could happen as a result of link errors, transaction retries, VR failures, etc., which might prevent the data from getting committed to persistent memory within the provided hold-up time after AC power fails;
(2) A runtime mechanism of periodically flushing the buffers is provided by an ISA (Instruction Set Architecture) called PCOMMIT. The problem is that PCOMMIT is only for processor generated write operations and in-bound IO write operations still need to rely on ADR to achieve persistence; and/or
(3) PCOMMIT also affects the data throughput to a persistent memory device due to the latency associated with flushing the WPQ in runtime and getting the completions back. It also requires that existing software need to be modified to comprehend PCOMMIT.

To address these issues, an embodiment ensures durability of data that is residing in volatile buffers (such as one or more of memory buffer(s), IIO buffer(s), etc.), in the face of platform failures. It also achieves this for both processor generated write operations and In-bound IO write operations. This is achieved without the PCOMMIT instruction for processor generated write operations, which in turn ensures data throughput and that software does not have to be modified to comprehend the PCOMMIT instruction.

In an embodiment, a (e.g., relatively small) non-volatile shadow buffer is provided inside the processor. This is not used under normal operations. In response to occurrence of an ADR event, the processor takes a snap-shot (or copy) the contents of the volatile buffers into this nonvolatile storage device. This can act as a non-volatile back up storage device for the data in the WPQ and IIO Buffers. If the NV shadow buffer is provided outside of the processor die, however, the link latency (i.e., the link between the backup buffer and volatile buffers) may or may not allow any time for the actual back up to finish (or even start).

Once the snap-shot of the volatile buffers are backed-up inside the processor, the ADR mechanism can then kick in (or take over) to flush the volatile buffers to persistent memory. If this flush is successful, then the back-up data can be discarded. If the flush is not successful (e.g., due to platform errors or failures), then the data can be recovered from the back-up image.

Furthermore, the Back-up store may be based on non-volatile technologies such as PCM, 3-Dimensional cross point memory, and/or Spin Torque Transfer Random Access Memory (STTRAM) in some embodiments. These technologies provide persistence without the relatively large write-latency associated with flash storage.

Fig. 3 illustrates a block diagram of various components present on a processor Integrated Circuit (IC) die 300, according to an embodiment. For example, processor die 300 may include the same or similar components as those discussed with reference to processors of Figs. 1-2 and 5-7 in various embodiments. As shown, processor die 300 includes a plurality of processor cores (labeled core 0 to core 7), L1/L2 coupled to each processor core as well as a pool of LLC (that are shared amongst the processor cores), and Cbox logic (labeled as Cbox 0 to Cbox 7, e.g., to provide coherence amongst the LLC devices). Each LLC may include a 20MB slice of LLC, but other slice sizes may be used depending on the implementation.

Referring to Fig. 3, one or more interconnects or buses 302 (such interconnects 104/112 discussed with reference to Fig. 1) couple various components of processor die 300 as shown. Processor die 300 also includes a physical layer (PHY) 304 to communicate with (e.g., two) Quick Path Interconnect (QPI) links (e.g., based on packets formed by QPI packet generation logic 306). Another physical layer logic 308 facilitates communication with (e.g., 4) SMI (Scalable Memory Interconnect) channels.

As discussed herein, WPQ or memory buffers generally refer to Write Pending Queue (WPQ) or buffers (labeled as "PI" in Fig. 3) inside the iMC 310. The data in the WPQ is waiting to be committed to memory, but are globally visible. This is flushed to memory on an ADR event. Also, ADR generally refers to a legacy mechanism, which provides an external trigger, that when activated causes the data in the WPQ, conceptually referred to as "ADR safe zone", to be flushed over to NVDIMM. The ADR pin is triggered by an early AC power detection circuitry. The detection of AC power loss implies a certain amount of DC power available to the system for ADR entry. This "hold up time" is a function of power supply design, system power consumption, and bulk capacitance. Generally, the hardware should guarantee that all the data in the "ADR Safe Zone" is flushed and committed to persistent memory, before the "hold up time" expires. Furthermore, ADR events discussed herein generally refer to events that lead to system reset or shutdown. ADR covers AC power failure, CF9 reset and thermal trip.

One embodiment includes the following components: NVM 152 (back-up of processor's volatile buffers on power failure or any other ADR event) and the ability to restore the data from the back-up image and commit it to persistent memory on next reboot. Moreover, as shown in the block diagram of Fig. 3, buffers in the iMC 310 (shown as PI) and in the IIO switch 312 (shown as P2) reside en route to persistent memory. NVM 152 inside processor die 300 is envisioned to be large enough to accommodate the data stored in the volatile buffers (such as one or more of memory buffer(s) including WPQ, IIO buffer(s), etc.).The combined IIO buffer and WPQ size may be less than 100 cache lines and hence a low capacity storage should suffice. Also, NVM 152 inside processor die 300 is envisioned to share the same power rail as the processor core(s) in an embodiment to allow for the NVM to stay operational at least as long as the processor core(s) that send the data to be backed up. In one embodiment, processor die 300 may include one or more capacitors (e.g., to store an additional charge provided to the NVM and/or processor core(s)) to increase the amount of time the NVM and/or processor core(s) remain operational after a power failure or ADR event. Additionally, processor die 300 may include one or more sensors (not shown) that are proximate to components of die 300 (such as the processor cores and/or PCU 314) to detect AC power loss or ADR event. These sensor(s) can in turn cause the start of data backup to the NVM 152 as described herein.

Moreover, any store operation that is done by software is considered complete once it is posted to the buffers (P1/P2) shown in this diagram. That the data is still residing in these buffers en route to NVDIMM is transparent to software and software at this point considers this as persistent data. Any system power failure or reset at this point may result in a silent data corruption since software considered this data as committed to persistent storage. ADR is a platform feature which provides an indication to the PCU 314 (Power Control Unit) in the processor 300 that the platform AC rails has failed. The DC rails may be active until the platform hold-up time and the flush should complete within this time. For example, a timer may be started that is consistent with the hold-up time, and cause a reset of the system once it expires. The PCU then sends a message to the iMC (sometimes called "ASyncSR"). In response to receipt of this message, the iMC blocks all further transactions, drains the WPQ and IIO Buffers, and puts the memory in self-refresh, at which point the flush is considered successful. If the DC rails loose power before memory is put in self-refresh, then the flush has failed and data might be lost.

In one embodiment, NVM 152 also provides/stores a bit flag (which may be called "NvBackUpVaild"), e.g., at a predetermined location. Depending on the implementation, if this flag is set, then data in the NV back-up is considered to be valid. And, if the flag is clear, then the NV back-up data is considered to be invalid (and should not be used).

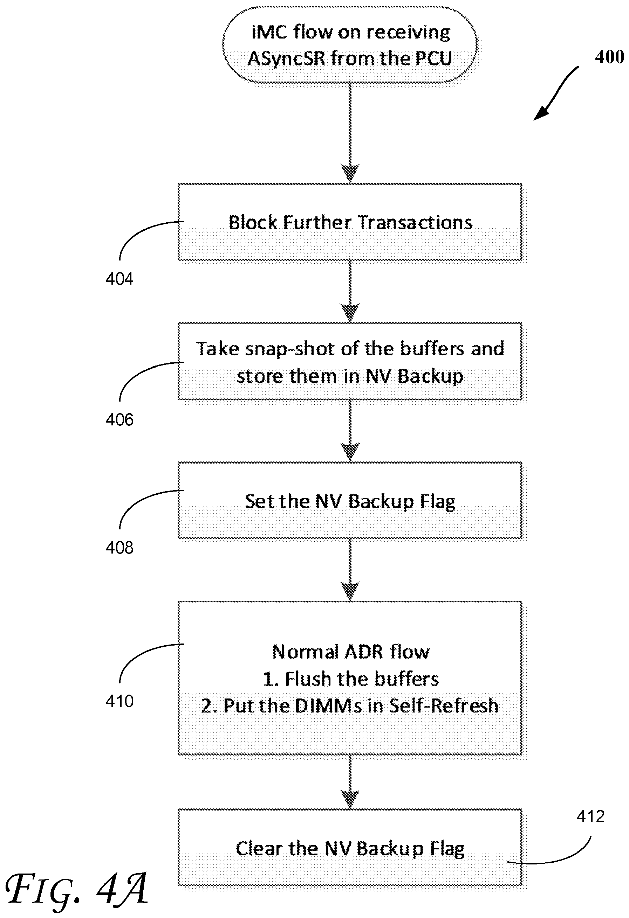

Fig. 4A illustrates a flow diagram of a method 400 that is performed in response to an indication of a failure, in accordance with an embodiment. For example, method 400 may be performed (e.g., in iMC 310 of Fig. 3) in response to receipt of a signal (e.g., ASyncSR) indicating a power failure (or another ADR event) has started. In one embodiment, various components discussed with reference to Figs. 1-3 and 5-7 may be utilized to perform one or more of the operations discussed with reference to Fig. 4A. In an embodiment, one or more operations of method 400 are implemented in logic (e.g., firmware), such as logic 150 and/or controller 120 of Fig. 1 and/or other memory controllers (such as IMC 310) discussed with reference to the other figures.

Referring to Figs. 1 through 4A, at an operation 404 (e.g., in response to an ADR event and a subsequent AsyncSR command from the PCU 314), blocks further transactions. Operation 406 takes a snap-shot of the volatile buffers and stores them in NV back up (e.g., NVM 152). At operation 408, the NV backup flag is set (or cleared depending on the implementation). At operation 410, normal ADR flow is followed (e.g., volatile buffers flushed and main memory/DIMMs put into self-refresh). At operation 412, the NV backup flag is cleared (or set depending on the implementation).

Furthermore, operation 410 (normal ADR flow) is vulnerable to platform errors and failures. If the flush is successful, then the NvBackUpValid is cleared at operation 412 and hence the backup contents can be discarded. But, if the flush fails or could not be completed before the hold-up time, then the system resets.

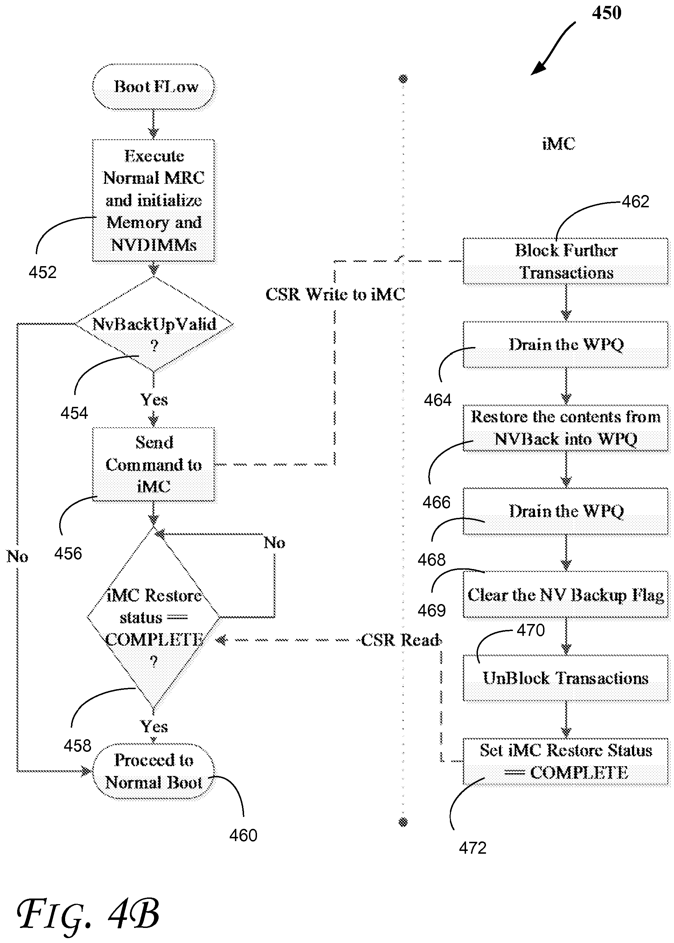

Fig. 4B illustrates a flow diagram of a method 450 to restore data on a next reboot, in accordance with an embodiment. For example, method 450 may be performed (e.g., the left side of Fig. 4B by BIOS (Basic Input/Output System) and the right side of Fig. 4B by the iMC 310) during a reboot after operation 412 of Fig. 4A. In various embodiments, various components discussed with reference to Figs. 1-3 and 5-7 may be utilized to perform one or more of the operations discussed with reference to Fig. 4B. In an embodiment, one or more operations of method 450 are implemented in logic (e.g., firmware), such as BIOS, logic 150, and/or controller 120 of Fig. 1 and/or other memory controllers (such as IMC 310) discussed with reference to the other figures.

Referring to Figs. 1 through 4B, at an operation 452 (e.g., after operation 412 of Fig. 4A and on the next reboot), BIOS executes normal MRC (Memory Reference Code) and initialize memory and NVDIMMs and check (454) the NvBackUpValid bit (e.g., in each iMC). If this bit is clear, BIOS skips the rest of the operations and proceed to normal boot (460). Otherwise, if the bit is set (454), BIOS sends a command (e.g., via a CSR write) to the iMC (456) to restore the backup. In response, iMC: blocks further transactions (462), drains any outstanding transactions (464), restores the contents from the NV Backup into the WPQ (466), drains the WPQ (468) (data is now recovered), clears NvBackUpVaild flag (469), unblocks transactions (470), and sends status back to the BIOS indicating restoration operations are complete (472).

Furthermore, after operation 456 (in addition to performance of operation 462), method 450 performs operation 458 to determine whether the iMC restoration is complete (e.g., after operation 472) and if so proceeds to normal boot at operation 460.

In some embodiments IO persistency or processor core persistence without utilization of PCOMMIT instruction may be performed as follows. On an ADR event and a subsequent AsyncSR command from the PCU, the iMC: (1) iMC takes a snap-shot of writes in the NVDIMMTPQ (Transaction Pending Queue); (2) iMC Blocks further incoming reads/writes to NVDIMM; (3) takes a snap-shot of the buffers and stores them in the NV Backup; (4) sets the NvBackUpValid flag; (5) continues with the normal ADR flow (e.g., sends writes in NVDIMM TPQ to non-volatile memory controller and after all snapshot writes are sent, iMC sends the ADR power failure command to NVDIMM); (6) iMC then clears NvBackUpValid.

Moreover, operation (5) above (normal ADR flow) is vulnerable to platform errors and failures. If the flush is successful, then the NvBackUpValid is cleared and hence the back-up contents can be discarded. But if the flush fails or could not be completed before the hold-up time, then the system resets. On the next reboot BIOS: (a) executes normal MRC and initialize memory and NVDIMMs; (b) checks the NvBackUpValid bit in iMC; (c) if the NvBackUpValid bit is clear, then BIOS skips the rest of the steps and proceed to normal boot; (d) if the NvBackUpValid bit is set, then BIOS sends a command (e.g., via a CSR write operation) to the iMC to restore the backup. The iMC then: (i) blocks further transactions; (ii) drains any outstanding transactions; (iii) restores the contents from the NV Backup into the WPQ; (iv) drains the WPQ (Data is now recovered); (v) clears NvBackUpVaild flag; (vi) unblocks transactions; and (vii) sends status information back to the BIOS indicating the restoration is complete.

Accordingly, current implementations do not guarantee durability of the data that software considers durable. While the current solutions may work for normal conditions, any platform failures or error conditions (e.g., link errors, retries, VR failures, etc.) may lead to loss of data. This is not acceptable, since the software has already written the data to persistent memory and considers it durable and platform should keep its "promise" to make it durable. To this end, an embodiment ensures data integrity even in the face of platform failures or error conditions. By backing-up the volatile buffers as soon as the AC power fails, it ensures that a failure to flush these buffers to persistent memory does not result in a data loss and can be recovered during the next reboot, and committed to the persistent memory range that it was directed to, before OS (Operating System) hand-off.

Fig. 5 illustrates a block diagram of a computing system 500 in accordance with an embodiment of the invention. The computing system 500 may include one or more central processing unit(s) (CPUs) 502 or processors that communicate via an interconnection network (or bus) 504. The processors 502 may include a general purpose processor, a network processor (that processes data communicated over a computer network 503), an application processor (such as those used in cell phones, smart phones, etc.), or other types of a processor (including a reduced instruction set computer (RISC) processor or a complex instruction set computer (CISC)). Various types of computer networks 503 may be utilized including wired (e.g., Ethernet, Gigabit, Fiber, etc.) or wireless networks (such as cellular, 3G (Third-Generation Cell-Phone Technology or 3rd Generation Wireless Format (UWCC)), 5G, Low Power Embedded (LPE), etc.). Moreover, the processors 502 may have a single or multiple core design. The processors 502 with a multiple core design may integrate different types of processor cores on the same integrated circuit (IC) die. Also, the processors 502 with a multiple core design may be implemented as symmetrical or asymmetrical multiprocessors.

In an embodiment, one or more of the processors 502 may be the same or similar to the processors 102 of Fig. 1. For example, one or more of the processors 502 may include one or more of the cores 106 and/or cache 108. Also, the operations discussed with reference to Figs. 1-4 may be performed by one or more components of the system 500.

A chipset 506 may also communicate with the interconnection network 504. The chipset 506 may include a graphics and memory control hub (GMCH) 508. The GMCH 508 may include a memory controller 510 (which may be the same or similar to the memory controller 120 of Fig. 1 in an embodiment) that communicates with the memory 114. System 500 may also include logic 150 (e.g., coupled to NVM 152) in various locations (such as those shown in Fig. 5 but can be in other locations within system 500 (not shown)). Also, NVM 152 may be present in various locations such as shown in Fig. 5.

Memory 114 may store data, including sequences of instructions that are executed by the CPU 502, or any other device included in the computing system 500. In one embodiment of the invention, the memory 114 may include one or more volatile storage (or memory) devices such as random access memory (RAM), dynamic RAM (DRAM), synchronous DRAM (SDRAM), static RAM (SRAM), or other types of storage devices. Nonvolatile memory may also be utilized such as a hard disk, flash, byte addressable 3-Dimensional Cross Point Memory (such as PCM), Resistive Random Access Memory, NAND memory, NOR memory and STTRAM. Additional devices may communicate via the interconnection network 504, such as multiple CPUs and/or multiple system memories.

The GMCH 508 may also include a graphics interface 514 that communicates with a graphics accelerator 516. In one embodiment of the invention, the graphics interface 514 may communicate with the graphics accelerator 516 via an accelerated graphics port (AGP) or Peripheral Component Interconnect (PCI) (or PCI express (PCIe) interface). In an embodiment of the invention, a display 517 (such as a flat panel display, touch screen, etc.) may communicate with the graphics interface 514 through, for example, a signal converter that translates a digital representation of an image stored in a storage device such as video memory or system memory into display signals that are interpreted and displayed by the display. The display signals produced by the display device may pass through various control devices before being interpreted by and subsequently displayed on the display 517.

A hub interface 518 may allow the GMCH 508 and an input/output control hub (ICH) 520 to communicate. The ICH 520 may provide an interface to I/O devices that communicate with the computing system 500. The ICH 520 may communicate with a bus 522 through a peripheral bridge (or controller) 524, such as a peripheral component interconnect (PCI) bridge, a universal serial bus (USB) controller, or other types of peripheral bridges or controllers. The bridge 524 may provide a data path between the CPU 502 and peripheral devices. Other types of topologies may be utilized. Also, multiple buses may communicate with the ICH 520, e.g., through multiple bridges or controllers. Moreover, other peripherals in communication with the ICH 520 may include, in various embodiments, integrated drive electronics (IDE) or small computer system interface (SCSI) hard drive(s), USB port(s), a keyboard, a mouse, parallel port(s), serial port(s), floppy disk drive(s), digital output support (e.g., digital video interface (DVI)), or other devices.

The bus 522 may communicate with an audio device 526, one or more disk drive(s) 528, and a network interface device 530 (which is in communication with the computer network 503, e.g., via a wired or wireless interface). As shown, the network interface device 530 may be coupled to an antenna 531 to wirelessly (e.g., via an Institute of Electrical and Electronics Engineers (IEEE) 802.11 interface (including IEEE 802.11a/b/g/n, etc.), cellular interface, 3G, 5G, LPE, etc.) communicate with the network 503. Other devices may communicate via the bus 522. Also, various components (such as the network interface device 530) may communicate with the GMCH 508 in some embodiments. In addition, the processor 502 and the GMCH 508 may be combined to form a single chip. Furthermore, the graphics accelerator 516 may be included within the GMCH 508 in other embodiments.

Furthermore, the computing system 500 may include volatile and/or nonvolatile memory (or storage). For example, nonvolatile memory may include one or more of the following: read-only memory (ROM), programmable ROM (PROM), erasable PROM (EPROM), electrically EPROM (EEPROM), a disk drive (e.g., 528), a floppy disk, a compact disk ROM (CD-ROM), a digital versatile disk (DVD), flash memory, a magneto-optical disk, or other types of nonvolatile machine-readable media that are capable of storing electronic data (e.g., including instructions).
Fig. 6 illustrates a computing system 600 that is arranged in a point-to-point (PtP) configuration, according to an embodiment. In particular, Fig. 6 shows a system where processors, memory, and input/output devices are interconnected by a number of point-to-point interfaces. The operations discussed with reference to Figs. 1-5 may be performed by one or more components of the system 600.

As illustrated in Fig. 6, the system 600 may include several processors, of which only two, processors 602 and 604 are shown for clarity. The processors 602 and 604 may each include a local memory controller hub (MCH) 606 and 608 to enable communication with memories 610 and 612. The memories 610 and/or 612 may store various data such as those discussed with reference to the memory 114 or NVM 152 of Figs. 1 and/or 5. Also, MCH 606 and 608 may include the memory controller 120 and/or logic 150 of Fig. 1 in some embodiments. Also, NVM 152 may be present in various locations such as shown in Fig. 6.

In an embodiment, the processors 602 and 604 may be one of the processors 502 discussed with reference to Fig. 5. The processors 602 and 604 may exchange data via a point-to-point (PtP) interface 614 using PtP interface circuits 616 and 618, respectively. Also, the processors 602 and 604 may each exchange data with a chipset 620 via individual PtP interfaces 622 and 624 using point-to-point interface circuits 626, 628, 630, and 632. The chipset 620 may further exchange data with a high-performance graphics circuit 634 via a high-performance graphics interface 636, e.g., using a PtP interface circuit 637. As discussed with reference to Fig. 5, the graphics interface 636 may be coupled to a display device (e.g., display 517) in some embodiments.

As shown in Fig. 6, one or more of the cores 106 and/or cache 108 of Fig. 1 may be located within the processors 602 and 604. Other embodiments, however, may exist in other circuits, logic units, or devices within the system 600 of Fig. 6. Furthermore, other embodiments may be distributed throughout several circuits, logic units, or devices illustrated in Fig. 6.

The chipset 620 may communicate with a bus 640 using a PtP interface circuit 641. The bus 640 may have one or more devices that communicate with it, such as a bus bridge 642 and I/O devices 643. Via a bus 644, the bus bridge 642 may communicate with other devices such as a keyboard/mouse 645, communication devices 646 (such as modems, network interface devices, or other communication devices that may communicate with the computer network 503, as discussed with reference to network interface device 530 for example, including via antenna 531), audio I/O device, and/or a data storage device 648. The data storage device 648 may store code 649 that may be executed by the processors 602 and/or 604.

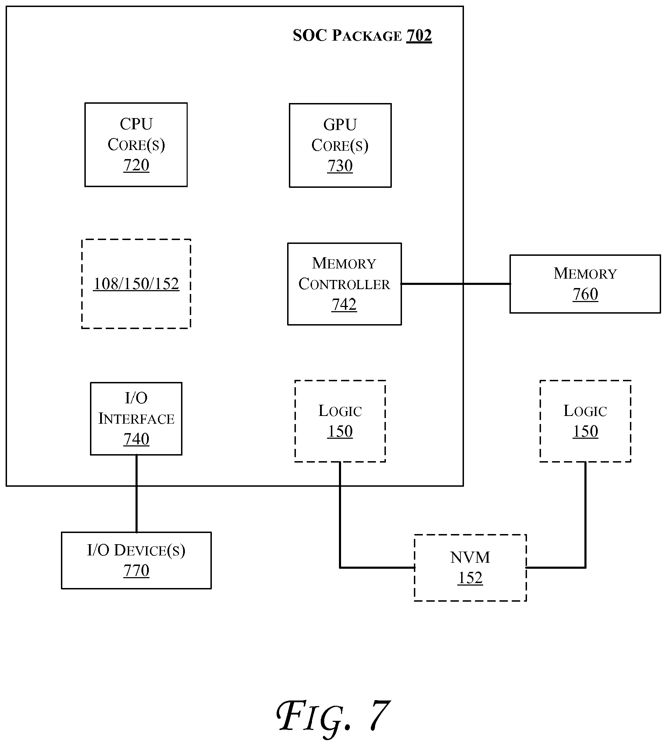

In some embodiments, one or more of the components discussed herein can be embodied on a System On Chip (SOC) device. Fig. 7 illustrates a block diagram of an SOC package in accordance with an embodiment. As illustrated in Fig. 7, SOC 702 includes one or more Central Processing Unit (CPU) cores 720, one or more Graphics Processor Unit (GPU) cores 730, an Input/Output (I/O) interface 740, and a memory controller 742 (which may be similar to or the same as memory controller 120 and/or logic 150). Various components of the SOC package 702 may be coupled to an interconnect or bus such as discussed herein with reference to the other figures. Also, the SOC package 702 may include more or less components, such as those discussed herein with reference to the other figures. Further, each component of the SOC package 720 may include one or more other components, e.g., as discussed with reference to the other figures herein. In one embodiment, SOC package 702 (and its components) is provided on one or more Integrated Circuit (IC) die, e.g., which are packaged onto a single semiconductor device.

As illustrated in Fig. 7, SOC package 702 is coupled to a memory 760 (which may be similar to or the same as memory discussed herein with reference to the other figures) via the memory controller 742. In an embodiment, the memory 760 (or a portion of it) can be integrated on the SOC package 702.

The I/O interface 740 may be coupled to one or more I/O devices 770, e.g., via an interconnect and/or bus such as discussed herein with reference to other figures. I/O device(s) 770 may include one or more of a keyboard, a mouse, a touchpad, a display, an image/video capture device (such as a camera or camcorder/video recorder), a touch screen, a speaker, or the like. Furthermore, SOC package 702 may include/integrate the logic 150 and/or memory controller 120 in an embodiment. Alternatively, the logic 150 and/or memory controller 120 may be provided outside of the SOC package 702 (i.e., as a discrete logic). Also, NVM 152 may be present in various locations such as shown in Fig. 7.

In various embodiments, the operations discussed herein, e.g., with reference to Figs. 1-7, may be implemented as hardware (e.g., circuitry), software, firmware, microcode, or combinations thereof, which may be provided as a computer program product, e.g., including a tangible (e.g., non-transitory) machine-readable or computer-readable medium having stored thereon instructions (or software procedures) used to program a computer to perform a process discussed herein. Also, the term "logic" may include, by way of example, software, hardware, or combinations of software and hardware. The machine-readable medium may include a storage device such as those discussed with respect to Figs. 1-7.

Additionally, such tangible computer-readable media may be downloaded as a computer program product, wherein the program may be transferred from a remote computer (e.g., a server) to a requesting computer (e.g., a client) by way of data signals (such as in a carrier wave or other propagation medium) via a communication link (e.g., a bus, a modem, or a network connection).

Reference in the specification to "one embodiment" or "an embodiment" means that a particular feature, structure, or characteristic described in connection with the embodiment may be included in at least an implementation. The appearances of the phrase "in one embodiment" in various places in the specification may or may not be all referring to the same embodiment.

Also, in the description and claims, the terms "coupled" and "connected," along with their derivatives, may be used. In some embodiments, "connected" may be used to indicate that two or more elements are in direct physical or electrical contact with each other. "Coupled" may mean that two or more elements are in direct physical or electrical contact. However, "coupled" may also mean that two or more elements may not be in direct contact with each other, but may still cooperate or interact with each other.

Thus, although embodiments have been described in language specific to structural features and/or methodological acts, it is to be understood that claimed subject matter may not be limited to the specific features or acts described. Rather, the specific features and acts are disclosed as sample forms of implementing the claimed subject matter.

## Claims

1. An apparatus comprising:
a processor (102) arranged to be coupled to non-volatile memory (152) which stores data from one or more volatile buffers of the processor;
one or more sensors to detect occurrence of an event that is to lead to a system reset or shut down;
one or more capacitors, coupled to the non-volatile memory, to increase an amount of time the non-volatile memory remains operational after occurrence of the event; and
logic (150) to cause storage of the data from the one or more volatile buffers of the processor into the non-volatile memory in response to occurrence of the event;
**characterised in that**:
the processor includes a non-volatile shadow buffer formed therewithin, wherein in response to the one or more sensors detecting occurrence of the event, the processor is configured to:
copy the data from the one or more volatile buffers into the non-volatile shadow buffer to be stored as backup data; and either:
discard the backup data, if the data from the one or more volatile buffers is successfully stored into the non-volatile memory; or
copy the backup data from the non-volatile shadow buffer into the non-volatile memory, if the data from the one or more volatile buffers is not successfully stored into the non-volatile memory.

2. The apparatus of claim 1, further comprising a Power Control Unit, PCU, (314) to generate a signal to indicate occurrence of the event.

3. The apparatus of claim 1, wherein the processor and the non-volatile memory are to be coupled to the same power rail.

4. The apparatus of claim 1, comprising logic (310) to block further transactions in response to occurrence of the event.

5. The apparatus of claim 1, wherein the logic is to update a flag to indicate start of storage of the data from the one or more volatile buffers of the processor into the nonvolatile memory, or wherein the logic is to update a flag to indicate completion of storage of the data from the one or more volatile buffers of the processor into the nonvolatile memory, or wherein one or more of the processor having one or more processor cores, the non-volatile memory, and the logic are on a same integrated circuit die (300).

6. The apparatus of claim 1, wherein the event corresponds to an Alternating Current, AC, power failure.

7. The apparatus of claim 1, wherein the processor is to comprise the logic.

8. The apparatus of claim 1, wherein the one or more volatile buffers are to comprise one or more non-volatile DIMMs, Dual Inline Memory Modules.

9. The apparatus of claim 1, wherein the non-volatile memory is to comprise one or more of: nanowire memory, Ferro-electric transistor random access memory, FeTRAM, magnetoresistive random access memory, MRAM, flash memory, Spin Torque Transfer Random Access Memory, STTRAM, Resistive Random Access Memory, byte addressable 3-Dimensional Cross Point Memory, Phase Change Memory, PCM.

10. A method performed by an apparatus, the apparatus includes a processor, one or more sensors, one or more capacitors, and logic, the method comprising:
storing data from one or more volatile buffers of the processor in non-volatile memory coupled to the processor, wherein the one or more capacitors are coupled to the non-volatile memory to increase an amount of time the non-volatile memory remains operational after occurrence of the event;
detecting, by the one or more sensors, an occurrence of an event that is to lead to a system reset or shut down;
copying the data from the one or more volatile buffers into a non-volatile shadow buffer formed within the processor to be stored as backup data, in response to occurrence of the event;
causing, by the logic, storage of the data from the one or more volatile buffers of the processor into the non-volatile memory, in response to occurrence of the event;
discarding, by the processor, the backup data, if the data from the one or more volatile buffers is successfully stored into the non-volatile memory; and
copying, by the processor, the backup data from the non-volatile shadow buffer into the non-volatile memory, if the data from the one or more volatile buffers is not successfully stored into the non-volatile memory.

11. The method of claim 10, wherein the apparatus further comprises a Power Control Unit, PCU, further comprising:
generating a signal, by the PCU, to indicate occurrence of the event.

12. The method of claim 10, wherein the processor and the non-volatile memory are coupled to the same power rail.

13. The method of claim 10, further comprising: blocking further transactions in response to occurrence of the event.

14. The method of claim 10, further comprising: updating a flag to indicate start of storage of the data from the one or more volatile buffers of the processor into the non-volatile memory, or further comprising updating a flag to indicate completion of storage of the data from the one or more volatile buffers of the processor into the non-volatile memory.

15. The method of claim 10, wherein the event corresponds to an Alternating Current, AC, power failure.

## Patentansprüche

1. Vorrichtung, umfassend:
einen Prozessor (102), der ausgelegt ist zum Gekoppeltwerden an einen nichtflüchtigen Speicher (152), der Daten von einem oder mehreren flüchtigen Puffern des Prozessors speichert;
einen oder mehrere Sensoren zum Detektieren des Auftretens eines Ereignisses, das zu einem System-Reset oder -Shutdown führen wird;
einen oder mehrere Kondensatoren, an den nichtflüchtigen Speicher gekoppelt, zum Vergrößern einer Zeitdauer, während der der nichtflüchtige Speicher nach dem Auftreten des Ereignisses betriebsfähig bleibt; und
eine Logik (150) zum Bewirken einer Ablage der Daten von dem einen oder den mehreren flüchtigen Puffern des Prozessors in den nichtflüchtigen Speicher als Reaktion auf ein Auftreten des Ereignisses;
**dadurch gekennzeichnet, dass**:
der Prozessor einen darin gebildeten nichtflüchtigen Schattenpuffer enthält, wobei als Reaktion darauf, dass der eine oder die mehreren Sensoren ein Auftreten des Ereignisses detektieren, der Prozessor ausgelegt ist zum:
Kopieren der Daten von dem einen oder den mehreren flüchtigen Puffern in den nichtflüchtigen Schattenpuffer zur Speicherung als Backup-Daten; und entweder:
Verwerfen der Backup-Daten, falls die Daten von dem einen oder den mehreren flüchtigen Puffern erfolgreich in dem nichtflüchtigen Speicher gespeichert sind; oder
Kopieren der Backup-Daten von dem nichtflüchtigen Schattenpuffer in den nichtflüchtigen Speicher, falls die Daten von dem einen oder den mehreren flüchtigen Puffern nicht erfolgreich in dem nichtflüchtigen Speicher gespeichert sind.

2. Vorrichtung nach Anspruch 1, weiter umfassend eine Power Control Unit, PCU, (314) zum Generieren eines Signals, zum Anzeigen eines Auftretens des Ereignisses.

3. Vorrichtung nach Anspruch 1, wobei der Prozessor und der nichtflüchtige Speicher an die gleiche Stromschiene gekoppelt werden sollen.

4. Vorrichtung nach Anspruch 1, umfassend eine Logik (310) zum Blockieren weiterer Transaktionen als Reaktion auf ein Auftreten des Ereignisses.

5. Vorrichtung nach Anspruch 1, wobei die Logik ein Flag aktualisieren soll zum Anzeigen des Starts einer Ablage der Daten von dem einen oder den mehreren flüchtigen Puffern des Prozessors in den nichtflüchtigen Speicher, oder wobei die Logik ein Flag aktualisieren soll, um einen Abschluss einer Ablage der Daten von dem einen oder den mehreren flüchtigen Puffern des Prozessors in den nichtflüchtigen Speicher anzuzeigen, oder wobei sich einer oder mehrere der Prozessoren mit einem oder mehreren Prozessorkernen, der nichtflüchtige Speicher und die Logik auf einem gleichen integrierten Schaltungs-Die (300) befinden.

6. Vorrichtung nach Anspruch 1, wobei das Ereignis einem Wechselstrom-, AC-, Stromausfall entspricht.

7. Vorrichtung nach Anspruch 1, wobei der Prozessor die Logik umfassen soll.

8. Vorrichtung nach Anspruch 1, wobei der eine oder die mehreren flüchtigen Puffer einen oder mehrere nichtflüchtige DIMMs, Dual Inline Memory Modules, umfassen sollen.

9. Vorrichtung nach Anspruch 1, wobei der nichtflüchtige Speicher einen oder mehrere der Folgenden umfassen soll: Nanodrahtspeicher, FeTRAM (Ferro-electric Transistor Random Access Memory), MRAM (Magnetoresistive Random Access Memory), Flash-Speicher, STTRAM (Spin Torque Transfer Random Access Memory), einen resistiven Direktzugriffsspeicher, einen Byte-adressierbaren dreidimensionalen Cross Point Memory, Phasenwechselspeicher, PCM.

10. Verfahren, durch eine Vorrichtung durchgeführt, wobei die Vorrichtung einen Prozessor, einen oder mehrere Sensoren, einen oder mehrere Kondensatoren und eine Logik enthält, wobei das Verfahren umfasst:
Speichern von Daten von einem oder mehreren flüchtigen Puffern des Prozessors in einem an den Prozessor gekoppelten nichtflüchtigen Speicher, wobei der eine oder die mehreren Kondensatoren an den nichtflüchtigen Speicher gekoppelt sind, um eine Zeitdauer zu vergrößern, während der der nichtflüchtige Speicher nach einem Auftreten des Ereignisses betriebsfähig bleibt;
Detektieren, durch den einen oder die mehreren Sensoren, eines Auftretens eines Ereignisses, das zu einem System-Reset oder -Shutdown führen wird;
Kopieren der Daten von dem einen oder den mehreren flüchtigen Puffern in den nichtflüchtigen Schattenpuffer, der in dem Prozessor ausgebildet ist, zur Speicherung als Backup-Daten, als Reaktion auf ein Auftreten des Ereignisses;
Bewirken, durch die Logik, einer Ablage der Daten von dem einen oder den mehreren flüchtigen Puffern des Prozessors in den nichtflüchtigen Speicher als Reaktion auf ein Auftreten des Ereignisses;
Verwerfen, durch den Prozessor, der Backup-Daten, falls die Daten von dem einen oder den mehreren flüchtigen Puffern erfolgreich in dem nichtflüchtigen Speicher gespeichert sind; und
Kopieren, durch den Prozessor, der Backup-Daten von dem nichtflüchtigen Schattenpuffer in den nichtflüchtigen Speicher, falls die Daten von dem einen oder den mehreren flüchtigen Puffern nicht erfolgreich in dem nichtflüchtigen Speicher gespeichert sind.

11. Verfahren nach Anspruch 10, wobei die Vorrichtung weiter eine Power Control Unit, PCU, umfasst, weiter umfassend:
Generieren eines Signals durch die PCU, um ein Auftreten des Ereignisses anzuzeigen.

12. Verfahren nach Anspruch 10, wobei der Prozessor und der nichtflüchtige Speicher an die gleiche Stromschiene gekoppelt sind.

13. Verfahren nach Anspruch 10, weiter umfassend:
Blockieren weiterer Transaktionen als Reaktion auf ein Auftreten des Ereignisses.

14. Verfahren nach Anspruch 10, weiter umfassend:
Aktualisieren eines Flag, um einen Start einer Ablage der Daten von dem einen oder den mehreren flüchtigen Puffern des Prozessors in den nichtflüchtigen Speicher anzuzeigen, oder weiter umfassend das Aktualisieren eines Flag, um einen Abschluss einer Ablage der Daten von dem einen oder den mehreren flüchtigen Puffern des Prozessors in den nichtflüchtigen Speicher anzuzeigen.

15. Verfahren nach Anspruch 10, wobei das Ereignis einem Wechselstrom-, AC-, Stromausfall entspricht.

## Revendications

1. Appareil comprenant :
un processeur (102) agencé pour être couplé à une mémoire non volatile (152) qui stocke des données d'une ou plusieurs mémoires tampons volatiles du processeur ;
un ou plusieurs capteurs pour détecter l'occurrence d'un événement qui va entraîner une réinitialisation ou un arrêt du système ;
un ou plusieurs condensateurs, couplés à la mémoire non volatile, pour augmenter une durée pendant laquelle la mémoire non volatile reste opérationnelle après l'occurrence de l'événement ; et
une logique (150) pour entraîner le stockage de données des une ou plusieurs mémoires tampons volatiles du processeur dans la mémoire non volatile en réponse à l'occurrence de l'événement ;
**caractérisé en ce que** :
le processeur renferme une mémoire tampon fantôme non volatile, le processeur étant configuré pour, en réponse à la détection de l'occurrence de l'événement par les un ou plusieurs capteurs :
copier les données des une ou plusieurs mémoires volatiles dans la mémoire tampon fantôme non volatile en vue de les stocker en tant que données de sauvegarde ; et soit :
ignorer les données de sauvegarde si les données des une ou plusieurs mémoires tampons volatiles sont correctement stockées dans la mémoire non volatile ; soit
copier les données de sauvegarde de la mémoire tampon fantôme non volatile dans la mémoire non volatile, si les données des un ou plusieurs mémoires tampons volatiles ne sont pas correctement stockées dans la mémoire non volatile.

2. Appareil selon la revendication 1, comprenant en outre une unité de commande de puissance, PCU, (314) pour générer un signal servant à indiquer l'occurrence de l'événement.

3. Appareil selon la revendication 1, dans lequel le processeur et la mémoire non volatile sont destinés à être couplés au même rail d'alimentation.

4. Appareil selon la revendication 1, comprenant une logique (310) pour bloquer d'autres transactions en réponse à l'occurrence de l'événement.

5. Appareil selon la revendication 1, dans lequel la logique sert à mettre à jour un fanion pour indiquer le début du stockage des données des uns ou plusieurs mémoires tampons volatiles du processeur dans la mémoire non volatile, ou dans lequel la logique sert à mettre à jour un fanion pour indiquer l'achèvement du stockage des données des une ou plusieurs mémoires tampons volatiles du processeur dans la mémoire non volatile, ou dans lequel un ou plusieurs du processeur ayant un ou plusieurs cœurs de processeur, de la mémoire non volatile et de la logique se trouvent sur une même puce de circuit intégré (300).

6. Appareil selon la revendication 1, dans lequel l'événement correspond à une panne de courant alternatif, CA.

7. Appareil selon la revendication 1, dans lequel le processeur est destiné à comprendre la logique.

8. Appareil selon la revendication 1, dans lequel les une ou plusieurs mémoires tampons volatiles sont destinées à comprendre un ou plusieurs modules de mémoire à double rangée de connexions, DIMM, non volatiles.

9. Appareil selon la revendication 1, dans lequel la mémoire non volatile est destinée à comprendre une ou plusieurs des mémoires suivantes : mémoire nanofilaire, mémoire vive à transistor ferro-électrique, FeTRAM, mémoire vive magnétorésistive, MRAM, mémoire flash, mémoire vive à couple de transfert de spin, STTRAM, mémoire vive résistive, mémoire à points de croisement tridimensionnelle adressable par octet, mémoire à changement de phase, PCM.

10. Procédé réalisé par un appareil, l'appareil comportant un processeur, un ou plusieurs capteurs, un ou plusieurs condensateurs, et une logique, le procédé comprenant :
le stockage de données d'une ou plusieurs mémoires tampons volatiles du processeur dans une mémoire non volatile couplée au processeur, dans lequel les un ou plusieurs condensateurs sont couplés à la mémoire non volatile pour augmenter la durée pendant laquelle la mémoire non volatile reste opérationnelle après l'occurrence de l'événement ;
la détection, par les un ou plusieurs capteurs, d'une occurrence d'un événement qui va entraîner une réinitialisation ou un arrêt de système ;
la copie des données des une ou plusieurs mémoires tampons volatiles dans une mémoire tampon fantôme non volatile formée dans le processeur en vue de leur stockage en tant que données de sauvegarde, en réponse à l'occurrence de l'événement ;
la commande, par la logique, du stockage des données des une ou plusieurs mémoires tampons volatiles du processeur dans la mémoire non volatile, en réponse à l'occurrence de l'événement ;
la suppression, par le processeur, des données de sauvegarde, si les données des une ou plusieurs mémoires tampons volatiles sont correctement stockées dans la mémoire non volatile ; et
la copie, par le processeur, des données de sauvegarde de la mémoire tampon fantôme non volatile dans la mémoire non volatile, si les données des une ou plusieurs mémoires tampons volatiles ne sont pas correctement stockées dans la mémoire non volatile.

11. Procédé selon la revendication 10, dans lequel l'appareil comprend en outre une unité de commande de puissance, PCU, comprenant en outre :
la génération d'un signal, par la PCU, pour indiquer l'occurrence de l'événement.

12. Procédé selon la revendication 10, dans lequel le processeur et la mémoire non volatile sont couplés au même rail d'alimentation.

13. Procédé selon la revendication 10, comprenant en outre : le blocage d'autres transactions en réponse à l'occurrence de l'événement.

14. Procédé selon la revendication 10, comprenant en outre : la mise à jour d'un fanion pour indiquer le début du stockage des données des une ou plusieurs mémoires tampons volatiles du processeur dans la mémoire non volatile, ou comprenant en outre la mise à jour d'un fanion pour indiquer l'achèvement du stockage des données des une ou plusieurs mémoires tampons volatiles du processeur dans la mémoire non volatile.

15. Procédé selon la revendication 10, dans lequel l'événement correspond à une panne de courant alternatif, CA.
